# EUROPEAN PATENT SPECIFICATION

(11) **EP 2 911 139 B1**
(45) Date of publication and mention of the grant of the patent: **20.09.2017**
(21) Application number: 14195717.5
(22) Date of filing: 01.12.2014
(51) Int. Cl.: G09F 9/30, H05K 1/11, G02F 1/1345

(54) **Display apparatus**
Anzeigevorrichtung
Appareil d'affichage

(30) Priority: 24.02.2014 US 201461943640 P; 13.06.2014 KR 20140072403
(43) Date of publication of application: 26.08.2015
(73) Proprietor: Samsung Electronics Co., Ltd., Suwon-si, Gyeonggi-do (KR)
(72) Inventor: Jang, Hyo Jae, Gangwon-do (KR); Park, Chan Hong, Gyeonggi-do (KR); Bang, Jeong Ho, Seoul (KR); Lee, Jong Myung, Seoul (KR); Jeong, Sun Weon, Gyeonggi-do (KR); Choi, Hyeong Sik, Gyeonggi-do, (KR)
(74) Representative: Appleyard Lees IP LLP

(56) References cited:
- JP-A- H0 358 025
- JP-A- H07 325 315
- JP-A- 2000 187 452
- JP-A- 2001 109 391
- JP-A- 2010 145 731
- JP-U- H0 164 626
- KR-A- 20080 022 442
- US-A1- 2008 137 275
- US-A1- 2009 153 790
- US-A1- 2010 207 847
- US-A1- 2013 155 655

## Description

### BACKGROUND

### 1. Field

The present disclosure relates to a display apparatus.

### 2. Description of the Related Art

A display apparatus is an apparatus that visually displays data information such as characters, figures, and the like. The display apparatus includes a liquid crystal display device and a driving circuit that drives the liquid crystal display device. The liquid crystal display device is a passive optical device that does not emit light by itself. Therefore, the liquid crystal display device may display an image using a backlight unit attached to a rear surface of the liquid crystal display device.

In recent years, a related art curved display device having a curvature that is changed while proceeding in both right and left directions with respect to a center portion thereof has been used. When the related art display apparatus is formed with a curved surface, information displayed by the display apparatus can be recognized by people within a broad range regardless of directions.

The related art display apparatus includes a display panel on which an image is formed, a source printed circuit board that controls the display panel, and a flexible printed circuit board (PCB) that connects the display panel and the source printed circuit board. In the flexible PCB, a driving chip may be mounted. A bottom chassis in which a backlight unit is positioned may be provided on the rear side of the display panel.

The related art display panel is connected to one side of the flexible PCB, and the source printed circuit board is connected to the other side thereof. Therefore, when the flexible PCB is bent, the source printed circuit board may be positioned on the rear side of the related art display panel.

US2010/207847 A1 (KIM YONG-JIN) and US2013/0155655 A1 (Moungyoub Lee et al) describe examples of the related art.

### SUMMARY

According to the present invention there is provided an apparatus as set forth in the appended claims. Other features of the invention will be apparent from the dependent claims, and the description which follows.

Exemplary embodiments may provide a display apparatus that can prevent damage of a flexible PCB. According to the exemplary embodiments, when a display panel is formed with a curved surface, it is possible to prevent the flexible PCB from being torn by a tension applied to the flexible PCB. In addition, when the flexible PCB is bent, it is possible to prevent damage of a driving chip by the edges of a bottom chassis or the like.

Additional aspects of the exemplary embodiments will be set forth in part in the description which follows and, in part, will be obvious from the description, or may be learned by practice of the exemplary embodiments.

In accordance with one example, there may be provided a display apparatus which includes: a display panel configured to display an image; a source printed circuit board configured to control the display panel; and a flexible printed circuit board (PCB) that connects the display panel and the source printed circuit board, wherein a width of an upper end portion or a lower end portion of the flexible PCB is longer than a width of a center portion of the flexible PCB.

A driving chip may be disposed in the flexible PCB at a position biased to one of the source printed circuit board side and the display panel side and offset from a center portion of the flexible PCB.

Also, the driving chip may be disposed at the position biased to the source printed circuit board side and offset from the center of the flexible PCB, and disposed on a rear side of the display panel when the flexible PCB is bent.

Also, a plurality of source printed circuit boards may be provided.

Also, a cut portion incised toward an inner side of the flexible PCB may be disposed on at least one side of the flexible PCB.

Also, the flexible PCB may be provided so as to incline in a direction oblique with respect to one side end portion of the display panel or one side end portion of the source printed circuit board.

Also, when the plurality of source printed circuit boards are provided, an oblique direction of the flexible PCB connected to one source printed circuit board may be different from an oblique direction of the flexible PCB connected to the other source printed circuit board.

Also, the flexible PCB may include a first portion connected to one of the display panel and the source printed circuit board, a second portion connected to the other of the display panel and the source printed circuit board, and a connection portion which connects the first portion and the second portion.

Also, the first portion may extend away from one side end of the connection portion in a first direction, and the second portion may extend away from the other side end of the connection portion in a second direction.

Also, a bottom chassis may be disposed on a rear side of the display panel, and the flexible PCB may be bent so that the source printed circuit board is disposed on a rear side of the bottom chassis.

Also, when the flexible PCB is bent so as to wrap a part of the bottom chassis, the driving chip mounted in the flexible PCB may be disposed so as not to be interfered with by edges of the bottom chassis.

Also, when the flexible PCB is bent so as to wrap the part of the bottom chassis, the driving chip mounted in the flexible PCB may be disposed on the rear side of the display panel.

Also, when the flexible PCB is bent so as to wrap the part of the bottom chassis, the driving chip mounted in the flexible PCB may be disposed on a front side on which the display panel is disposed.

Also, a top chassis for fixing a front side of the display panel may be disposed on the front side of the display panel.

Also, a plurality of flexible PCBs may be provided, and a separation member may be positioned between the flexible PCBs adjacent to each other to support the top chassis.

In accordance with another example, there may be provided a display apparatus which includes: a display panel that is bent so as to have a predetermined curvature; a source printed circuit board configured to control the display panel; and a flexible printed circuit board (PCB) that connects the display panel and the source printed circuit board, and the flexible PCB includes a driving chip mounted at a position biased to the source printed circuit board side or the display panel side and offset from a center portion of the flexible PCB, wherein a part of at least one side edge of the flexible PCB extends in a direction oblique with respect to one end portion of the display panel.

Here, a plurality of source printed circuit boards may be provided.

Also, a cut portion may be disposed on the at least one side edge of the flexible PCB.

Also, the flexible PCB may be disposed so as to incline in a direction oblique with respect to one side end portion of the display panel or one side end portion of the source printed circuit board.

In accordance with still another example, there may be provided a display apparatus which includes: a bendable display panel; a plurality of source printed circuit boards configured to control the display panel; a plurality of flexible printed circuit boards (PCBs) that connect one side of the bendable display panel and one side of the source printed circuit boards; and a bottom chassis that includes a backlight unit and is disposed on a rear side of the bendable display panel, wherein a cut portion in which at least a part of the respective flexible PCBs is incised is disposed on at least one side of the respective flexible PCBs.

A driving chip may be disposed in each of the flexible PCBs and mounted at a position biased to the source printed circuit boards side or the bendable display panel side and offset from a center portion of the respective flexible PCBs.

Also, when the flexible PCBs are bent, the driving chip may be positioned on a rear side of the bendable display panel.

Also, the flexible PCBs may be disposed so as to incline in a direction oblique with respect to one side end portion of the bendable display panel or one side end portion of the source printed circuit boards.

In accordance with yet another example, there may be provided a display apparatus which includes: a bendable display panel; a source printed circuit board configured to control the bendable display panel; and a flexible printed circuit board (PCB) that connects the bendable display panel and the source printed circuit board, wherein a cut portion in which at least a part of the flexible PCB is incised is disposed on at least one side of the flexible PCB.

### BRIEF DESCRIPTION OF THE DRAWINGS

These and/or other examples of the present disclosure will become apparent and more readily appreciated from the following description, taken in conjunction with the accompanying drawings of which:
FIG. 1 is a perspective view showing a display apparatus in accordance with the present disclosure;
FIG. 2 is a view showing an example of a viewing angle of a display apparatus in accordance with the present disclosure;
FIGS. 3A and 3B are perspective views showing a display apparatus in accordance with the present disclosure;
FIG. 4 is an exploded perspective view showing a display module applied to a display apparatus in accordance with the present disclosure;
FIG. 5 is a schematic view showing a state of a display module in accordance with the present disclosure, when viewed from the side;
FIG. 6 is a view showing a state in which a flexible PCB of FIG. 4 is bent;
FIG. 7 is a schematic view showing a state of a display panel to which a flexible PCB in accordance with the present disclosure is applied, when viewed from the bottom;
FIG. 8 is a view showing a flexible PCB in accordance with the present disclosure;
FIG. 9 is a view showing a display module to which a flexible PCB in accordance with the present disclosure; and
FIG. 10 is a view showing a portion C of FIG. 9.

### DETAILED DESCRIPTION

Reference will now be made in detail to examples which are illustrated in the accompanying drawings, wherein like reference numerals refer to like elements throughout.

Hereinafter, a display apparatus in accordance with the present disclosure will be described in detail with the accompanying drawings.

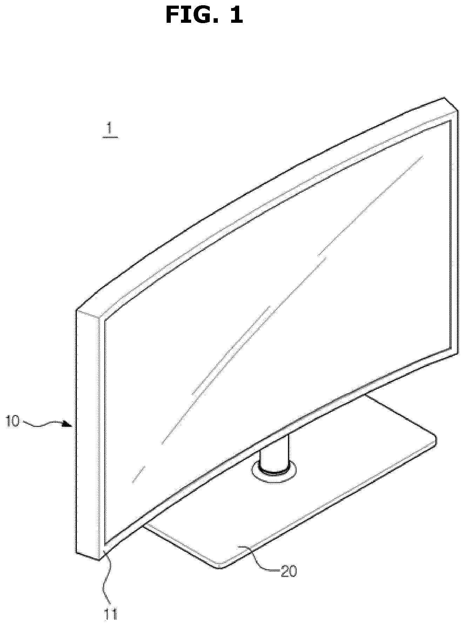

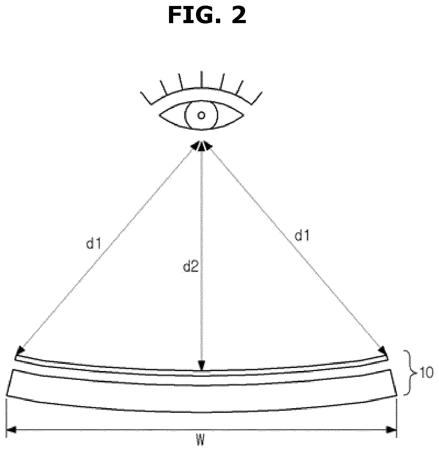

FIG. 1 is a perspective view showing a display apparatus in accordance with the present disclosure, and FIG. 2 is a view showing an example of a viewing angle of a display apparatus in accordance with the present disclosure.

Referring to FIG. 1 and FIG. 2, a display apparatus 1 is a device that displays images such as a television, a monitor, or the like. The display apparatus 1 may include a main body 10 that displays an image while having a predetermined curvature, and a stand 20 that is mounted on the bottom of the main body 10 to support the main body 10. The main body 10 may be provided on a wall using a bracket or the like without the stand 20.

The main body 10 includes an image display surface having a predetermined curvature in a width (W) direction. When a user is positioned in a front center of the main body 10, the main body 10 of the display apparatus 1 may be provided to have a predetermined curvature so that a distance d1 between left and right end portions of the image display surface and a visual field of the user positioned at a specific position and a distance d2 between the center of the image display surface and the visual field of the user are identical or similar to each other. That is, the left and right end portions of the display apparatus 1 are provided so as to protrude forward in relation to the center portion. The main body 10 is provided so as to have a predetermined curvature. Therefore, the user can view two-dimensional (2D) images having a three-dimensional (3D) effect or natural 3D images.

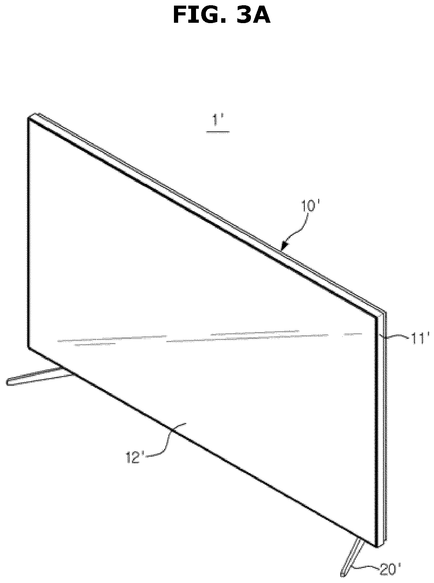

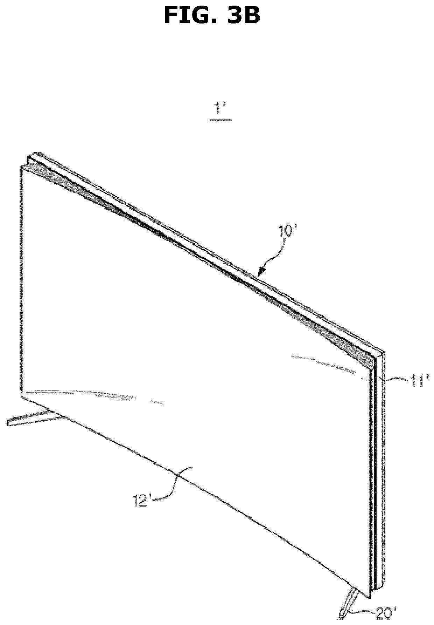

FIGS. 3A and 3B are perspective views showing a display apparatus in accordance with another example.

Referring to FIGS. 3A and 3B, a display apparatus 1' is deformably provided in such a manner that both ends of a display panel 12' protrude forward in relation to the center portion thereof.

A main body 10' of the display apparatus 1' includes a case 11', and the display panel 12' is accommodated in the case 11'. The main body 10' may be supported by a stand 20'. The main body 10' may be provided on a wall using a bracket or the like without the stand 20'.

The display panel 12' can be deformed so as to be in a flat surface state as shown in FIG. 3A, or deformed so that both side ends of the display panel 12' protrude forward to be in a curved surface state with a predetermined curvature.

As an example, the display panel 12' can be deformed to be in the flat surface state or the curved surface state by a driving device. The rear center of the display panel 12' is fixed to the case 11', and the driving device and both rear left and right sides of the display panel 12' can be connected by a hinge device. The hinge device receives a driving force from the driving device to push both left and right sides of the display panel 12' so that the display panel 12' protrudes forward, and pull the both left and right sides thereof so that the surface of display panel 12' becomes flat.

The user may use the display panel 12' by bending the display panel 12' or holding the display panel 12' in the flat surface state.

Hereinafter, the display apparatus 1 in accordance with the present disclosure will be described. Description of a structure of the flexible printed circuit board (PCB) applied to the display apparatus 1 in accordance with the present disclosure may be similarly applied to the display apparatus 1' in accordance with another example.

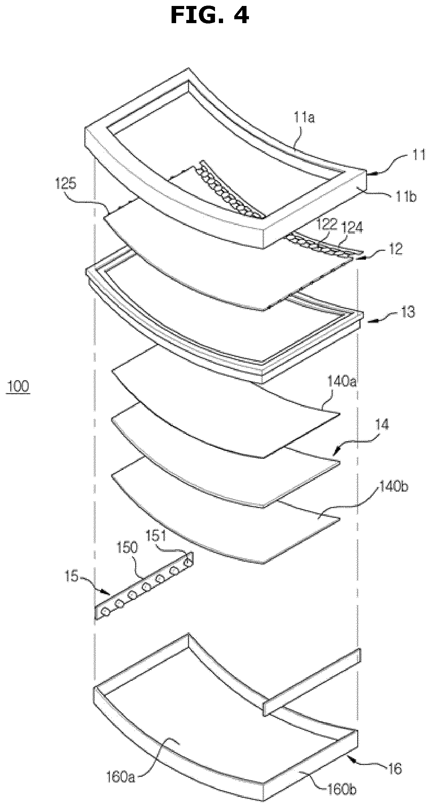

FIG. 4 is an exploded perspective view showing a display module applied to a display apparatus in accordance with the present disclosure.

Referring to FIG. 4, the display apparatus 1 includes a display module 100 that displays an image. The display module 100 includes a display panel 12, and a backlight unit 15 is disposed on a rear side of the display panel 12.

In a space between the display panel 12 and the backlight unit 15, a diffusing plate 14 for allowing light transmitted from the rear side to be diffused and transmitted to the display panel 12 positioned on the front side may be provided. The display panel 12 and the diffusing plate 14 may be supported by a middle mold 13, and a top chassis 11 is coupled to the front side of the middle mold 13, so that a state in which the display panel 12 is provided in the middle mold 13 is held.

A bottom chassis 16 is coupled to the rear side of the middle mold 13, and the backlight unit 15 is disposed on both inner sides of the bottom chassis 16. A light guide plate 140b is provided on the front side of the bottom chassis 16 so that light emitted from the backlight unit 15 can be uniformly dispersed. On the front side of the diffusing plate 14, optical sheets 140a for improving optical characteristics of light irradiated from the backlight unit 15 may be disposed.

The display panel 12 may be formed with a curvature that is changed depending on portions of the display panel 12 while proceeding toward both sides of the display panel 12 from the center portion thereof. In this instance, the display panel 12 may be formed with the curvature in which both sides are symmetric with each other with respect to the center portion of the display panel 12.

The display module 100 built in the display apparatus 1 may be formed with a curvature corresponding to the curvature of the display apparatus 1. Thus, each of the display panel 12, the diffusing plate 14, the middle mold 13, the top chassis 11, and the bottom chassis 16 which constitute the display module 100 is formed with a predetermined curvature. Therefore, both end portions of the respective component may protrude forward in relation to the center portion thereof. The curvatures of the respective components may be identical with each other, or different depending on a design.

The display panel 12 may be also defined as a liquid crystal display panel. The display panel 12 includes a thin film transistor substrate in which a thin film transistor is formed, a color filter substrate facing the thin film transistor substrate, and a liquid crystal layer provided between the thin film transistor substrate and the color filter substrate.

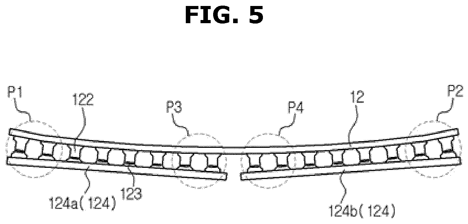

The display panel 12 includes a flexible PCB 122 provided on one side of the thin film transistor substrate, a driving chip 123 (e.g., driving chip 123 of FIG. 5) mounted in the flexible PCB 122, and a source printed circuit board 124 connected to the other side of the flexible PCB 122. On the side surface of the display panel 12, a gate driving unit 125 that drives gate lines of the display panel 12 may be further provided.

The backlight unit 15 may be disposed on both inner sides of the bottom chassis 16 to irradiate the inner center side of the bottom chassis 16 with light. The backlight unit 15 includes a pair of substrates 150 which extend vertically and are disposed on the inner side of both ends of the bottom chassis 16, and a plurality of light emitting diodes 151 which are disposed so as to be spaced apart from each other on the pair of substrates 150. The backlight unit 15 may be provided in various forms without being limited to the example shown in FIG. 5.

The display panel 12 and the top chassis 11 are sequentially provided on the front side of the middle mold 13. The bottom chassis 16 is provided on the rear side of the middle mold 13 to allow the display panel 12 and the bottom chassis 16 to be kept spaced apart from each other while supporting the respective components.

The top chassis 11 includes a bezel portion 11a that covers an external peripheral side of a front surface of the display panel 12 and a top side surface portion 11b that is bent toward the rear side of the display panel 12 at an end portion of the bezel portion 11a to cover a side surface of the middle mold 13.

The bottom chassis 16 includes a rear surface portion 160a that forms a rear surface of the display module 100 and a bottom side surface portion 160b that extends toward the front side of the display panel 12 from a periphery of the rear surface portion 160a to be coupled to the middle mold 13. The bottom chassis 16 is provided in the form of a curved surface in which both side ends of the bottom chassis 16 protrude forward in relation to the center portion thereof, Therefore, the rear surface portion 160a of the bottom chassis 16 is also provided in the form of a curved surface in which both side ends of the rear surface portion 160a protrude forward in relation to the center portion thereof. The bottom chassis 16 may be manufactured as a metal plate such as aluminum so that heat generated from the backlight unit 15 can be efficiently radiated.

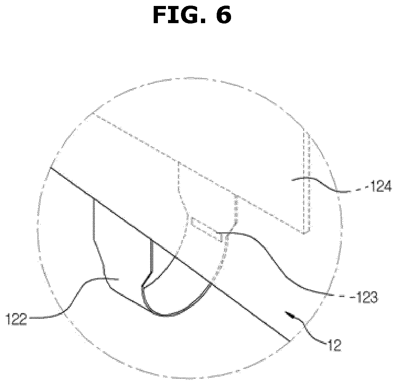

FIG. 5 is a schematic view showing a state of a display module in accordance with the present disclosure, when viewed from the side, and FIG. 6 is a view showing a state in which a flexible PCB of FIG. 4 is bent.

Referring to FIGS. 5 and 6, the source printed circuit board 124 for controlling the display panel 12 may be provided on the rear side of the display panel 12 in accordance with the present disclosure. The display panel 12 and the source printed circuit board 124 are connected with each other through a plurality of flexible PCBs 122. One side of the flexible PCB 122 may be bonded to the display panel 12, and the other side thereof may be bonded to the source printed circuit board 124.

The source printed circuit board 124 in accordance with the present embodiment includes a first source printed circuit board 124a and a second source printed circuit board 124b. The first source printed circuit board 124a may be positioned on a left side of the display panel 12, and the second source printed circuit board 124b may be positioned on a right side of the display panel 12. Each of the first source printed circuit board 124a and the second source printed circuit board 124b may be connected to the display panel 12 by the plurality of flexible PCBs 122. The number of source printed circuit boards 124 is not limited to the above-described embodiment, and the source printed circuit board 124 may be divided into a larger number of source printed circuit boards.

The flexible PCB 122 extends from the lower end of the display panel 12 toward the source printed circuit board 124 that is disposed on the lower rear side of the display panel 12 so as to be spaced apart from the display panel 12 to thereby connect the display panel 12 and the source printed circuit board 124. A circuit for transmitting electric power and signals may be provided inside the flexible PCB 122.

The flexible PCB 122 may be bent so as to connect the display panel 12 and the source printed circuit board 124 which are disposed in front and rear directions. The flexible PCB 122 may be bent into a U-shape so as to connect the display panel 12 and the source printed circuit board 124.

As an example, the flexible PCB 122 may extend to the external side of the bottom chassis 16, and be bent so as to wrap one end portion of the bottom chassis 16. When the flexible PCB 122 is bent, the source printed circuit board 124 connected to the other side of the flexible PCB 122 may be positioned on the rear side of the bottom chassis 16.

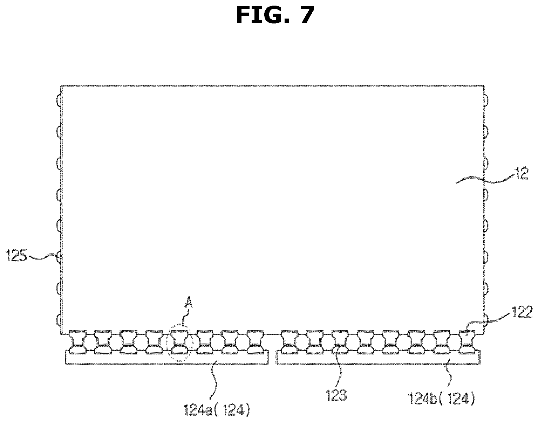

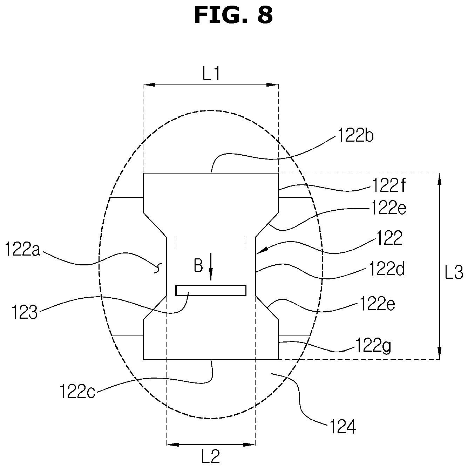

FIG. 7 is a schematic view showing a state of a display panel to which a flexible PCB in accordance with the present disclosure is applied, when viewed from the bottom, and FIG. 8 is a view showing a flexible PCB in accordance with the present disclosure.

When one side of the flexible PCB 122 is connected to the display panel 12 having a predetermined curvature and the other side thereof is connected to the first source printed circuit board 124a and the second source printed circuit board 124b, the first source printed circuit board 124a and the second source printed circuit board 124b may receive a force causing them to be bent corresponding to the curvature of the display panel 12.

In this instance, a tension may be applied to the flexible PCB 122 by the first source printed circuit board 124a and the second source printed circuit board 124b which are highly likely to be bent. A tension larger than that applied to the flexible PCBs 122 positioned in the middle portion may be applied to the flexible PCBs 122 positioned in both end portions P1, P2, P3, and P4 (see FIGS. 4-5) of each of the first and second source printed circuit boards 124a and 124b. The tension applied to the flexible PCBs 122 may be continuously applied to the flexible PCBs 122 after the display panel 12 and the source printed circuit board 124 are connected with each other by the flexible PCBs 122.

In a related art display apparatus, the flexible PCBs are formed into the same rectangular shape to connect the source printed circuit board and the display panel. In this instance, a tension larger than that applied to the flexible PCBs positioned in the middle portion of the first and second source printed circuit boards is applied to the flexible PCBs positioned in the both end portions P1, P2, P3, and P4 of each of the first and second source printed circuit boards. When the flexible PCBs positioned in the both end portions P1, P2, P3, and P4 are bent so as to wrap one end portion of the bottom chassis, e.g., when the tension is continuously applied to the flexible PCBs in a state in which both side edges of the flexible PCB are kept vulnerable to tension, damage such as tearing may occur. In this case, reliability and life of the related art display apparatus may be affected.

The flexible PCB 122 in accordance with the present disclosure may be deformable in its shape in such a manner that a magnitude of the tension applied to the edge sides of the flexible PCB 122 is reduced. As an example, the flexible PCB 122 may be provided into a shape in which at least one side of the rectangular shape is incised.

A cut portion 122a may be formed in one side or both sides of the flexible PCB 122. The cut portion 122a is formed. Therefore, a width L1 of an upper end portion 122b or a lower end portion 122c of the flexible PCB 122 may be formed longer than a width L2 of a middle portion 122d of the flexible PCB 122. At least partial edge 122e connecting the upper end portion 122b or the lower end portion 122c and the middle portion 122d may extend in a direction oblique with respect to the upper end portion 122b or the lower end portion 122c.

That is, in order for the at least partial edge 122e of side edges 122e, 122f, and 122g of the flexible PCB 122 not to extend along the shortest length L3 of the flexible PCB 122 connecting the display panel 12 and the source printed circuit board 124, the flexible PCB 122 may include a portion that extends while having a predetermined inclination angle with the lower end portion of the display panel 12 or with one end portion of the source printed circuit board 124, rather than being perpendicular thereto. When the flexible PCB 122 is bent, the at least partial edge 122e that extends in the oblique direction may be wound on one side end of the bottom chassis 16.

In this manner, the at least partial edge 122e that connects the upper end portion 122b or the lower end portion 122c of the flexible PCB 122 and the middle portion 122d thereof extends in the oblique direction. Therefore, a length of the side edges 122e, 122f, and 122g of the flexible PCB 122 may be longer than the shortest length L3 of the flexible PCB 122 connecting the display panel 12 and the source printed circuit board 124. The cut portion 122a is formed on the side of the flexible PCB 122 so that the length of the side edges 122e, 122f, and 122g of the flexible PCB 122 extending to the rear side of the bottom chassis 16 from the front side thereof is longer than the shortest length. Therefore, the flexible PCB 122 is prevented from being more tightly wound on the bottom chassis 16 compared to when the cut portion 122a is not formed on the side of the flexible PCB 122. As a result, a magnitude of the tension applied to the side edges of the flexible PCB 122 may be reduced in the examples of the present disclosure in comparison to the related art.

A separation member (not shown) for preventing the flexible PCB 122 from being brought into contact with the top chassis 11 may be positioned in the cut portion 122a of the flexible PCB 122. The separation member may be positioned between the flexible PCBs 122 adjacent to each other. The top chassis 11 is supported by the separation member. Therefore, it is possible to prevent the flexible PCB 122 from being damaged by friction with the top chassis 11 or the like when packing or transporting the display apparatus 1.

When the flexible PCB 122 is bent, the driving chip 123 mounted in the flexible PCB 122 may be positioned on the rear side of the bottom chassis 16. That is, the driving chip 123 may be provided in a position moved under a position of a related art driving chip (e.g., moved down in a B direction), within the flexible PCB 122.

Specifically, the driving chip 123 may be mounted in a position adjacent to the source printed circuit board 124. When the flexible PCB 122 is bent, the driving chip 123 mounted in the flexible PCB 122 may be provided so as to be positioned on the rear side of the bottom chassis 16. As a result, it is possible to prevent the driving chip 123 from being damaged by other components inside the display module 100.

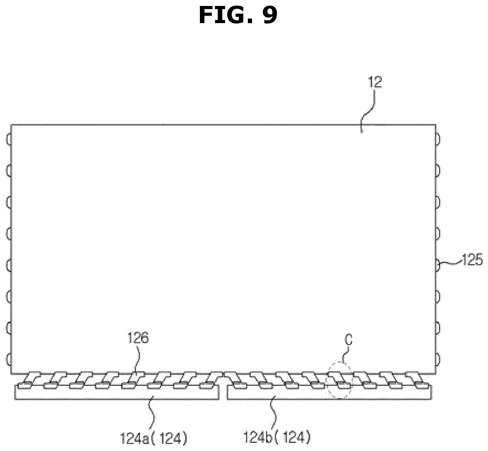

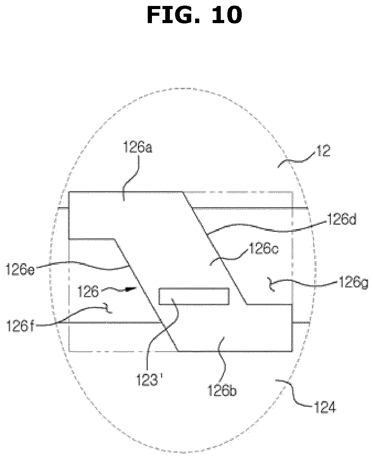

FIG. 9 is a view showing a display module to which a flexible PCB in accordance with another example is applied, and FIG. 10 is a view showing a portion C of FIG. 9.

Referring to FIGS. 9 and 10, a flexible PCB 126 in accordance with another example includes a connection portion 126c that connects a first portion 126a mounted in the display panel 12 and a second portion 126b mounted in the source printed circuit board 124. The connection portion 126c extends in an oblique direction.

That is, side edges 126d and 126e of the connection portion 126c may extend so as to have a predetermined inclination angle with the lower end portion of the display panel 12 or one end portion of the source printed circuit board 124, not extending along the shortest length between one end portion of the display panel 12 and the source printed circuit board 124.

For example, a part of side edges 126f and 126g of the flexible PCB 126 is incised so that the connection portion 126c may be provided so as to have the predetermined inclination angle with the lower end portion of the display panel 12 or the one end portion of the source printed circuit board 124.

The first portion 126a may extend on one side of the connection portion 126c in one direction, and the second portion 126b may extend on the other side thereof in the other direction. For example, as shown in FIG. 10, the first portion 126a of the flexible PCB 126 connected to the second source printed circuit board 124b may extend from the connection portion 126c in a left direction, and the second portion 126b may extend from the connection portion 126c in a right direction. In this instance, the connection portion 126c may extend from a left upper side toward a right lower side.

The inclination direction of the connection portion of the flexible PCB 126 connected to the first source printed circuit board 124a may be different from the inclination direction of the connection portion of the flexible PCB 126 connected to the second source printed circuit board 124b.

For example, the connection portion of the flexible PCB 126 connected to the first source printed circuit board 124a may be disposed from the right upper side toward the left lower side, and the connection portion of the flexible PCB 126 connected to the second source printed circuit board 124b may be disposed from the left upper side toward the right lower side. In this instance, the first portion 126a of the flexible PCB 126 connected to the first source printed circuit board 124a and the first portion 126a of the flexible PCB 126 connected to the second source printed circuit board 124b may be disposed so as to face each other. The first portion 126a of the flexible PCB 126 connected to the first source printed circuit board 124a may be disposed so as to face the second source printed circuit board 124b side, and the first portion 126a of the flexible PCB 126 connected to the second source printed circuit board 124b may be disposed so as to face the first source printed circuit board 124a side.

Therefore, the connection portion 126c is formed to extend in the oblique direction so that the lengths of the side edges 126d and 126e of the flexible PCB 126 are formed longer than the shortest length between the display panel 12 and the source printed circuit board 124. Therefore, the side edges 126d and 126e may not be tightened even though the flexible PCB 126 is bent so as to wrap one end portion of the bottom chassis 16. Thus, compared to when the lengths of the side edges 126d and 126e of the flexible PCB 126 are the same as the shortest length between the display panel 12 and the source printed circuit board 124, a magnitude of a tension applied to the side edges 126d and 126e of the flexible PCB 126 may be reduced to a greater degree.

A driving chip 123' may be mounted so as to be adjacent to the second portion 126b connected to the source printed circuit board 124. When the flexible PCB 126 is bent, the driving chip 123' mounted in the flexible PCB 126 may be positioned on the rear side of the bottom chassis 16. Thus, it is possible to prevent the driving chip 123' from being damaged by other components inside the display module 100.

A separation member (not shown) that enables the flexible PCB 126 and the top chassis 11 to be spaced apart from each other may be positioned in a space formed by the first portion 126a and the connection portion 126c and a space formed by the second portion 126b and the connection portion 126c, between the display panel 12 and the source printed circuit board 124. The separation member is provided to prevent the flexible PCB 126 from being damaged by the top chassis 11.

As described above, the side edges of the flexible PCBs 122 and 126 are formed to be oblique with respect to the lower end portion of the display panel 12 or the one end portion of the source printed circuit board 124. Therefore, the lengths of the side edges of the flexible PCBs 122 and 126 may be longer than the shortest length from the lower end of the display panel 12 to which one side of the flexible PCBs 122 and 126 is connected to the source printed circuit board 124 to which the other side of the flexible PCBs 122 and 126 is connected. Thus, the side edges of the flexible PCBs 122 and 126 may be provided with margins in their lengths even though the flexible PCBs 122 and 126 are wound on the bottom chassis 16. Therefore, in the examples of the present disclosure, a magnitude of a tension applied to the flexible PCBs 122 and 126 may be reduced to a greater degree compared to when the lengths of the side edges of the related art flexible PCB are the same as the shortest distance from the lower end of the display panel to the source printed circuit board. As a result it is possible to prevent damage of the flexible PCBs 122 and 126 provided in the display apparatus 1 having the predetermined curvature.

In addition, the driving chips 123 and 123' mounted in the flexible PCBs 122 and 126 are positioned so as to be adjacent to the source printed circuit board 124, so that it is possible to prevent damage of the flexible PCBs 122 and 126 when the flexible PCBs are wound on the edge of the bottom chassis 16 to be bent. In the above, a case in which the driving chips 123 and 123' are mounted in the flexible PCBs 122 and 126 adjacent to the source printed circuit board 124 has been described, but the positions of the driving chips 123 and 123' are not limited thereto. For example, the driving chips 123 and 123' may be positioned so as not to be damaged by the edges of the bottom chassis 16 or the like due to bending of the flexible PCBs 122 and 126. For example, the driving chips 123 and 123' may be positioned in the flexible PCBs 122 and 126 adjacent to the display panel 12.

By deforming the shape of the flexible PCB included in the display apparatus having the predetermined curvature, it is possible to prevent damage of the flexible PCB. In addition, by changing the position of the driving chip mounted in the flexible PCB, it is possible to prevent damage of the driving chip. As a result it is possible to increase the life of the display apparatus and improve reliability of a product.

As is apparent from the above description, the display apparatus in accordance with the present disclosure may prevent the damage of the flexible PCB or the driving chip when the display panel is formed with a curved surface.

## Claims

1. A display apparatus (1) comprising:
a display panel (12) formed with a curved surface and configured to display an image;
a source printed circuit board (124) configured to control the display panel (12); and
a flexible printed circuit board (122) (PCB) including :
a first portion (126a) connected to one side end curved portion of the curved display panel,
a second portion (126b) connected to one side end portion of the source printed circuit board (124); and
a connection portion (126c) which connects the first portion to the second portion, the connection portion (126c) having side edges (126d, 126e);
**characterised in that**:
the side edges (126d, 126e) of the connection portion (126c) extend at a predetermined oblique angle with respect to :
said one side end curved portion of the display panel (12) or
said one side end portion of the source PCB (124)
such that the connection portion (126c) is longer than the shortest length between the display panel (12) and the printed circuit board (124);
wherein the first portion (126a) of the flexible PCB (122) extends away from one side end of the connection portion (126c) in a first direction, and
the second portion (126b) of the flexible PCB (122) extends away from the other side end of the connection portion (126c) in a second direction;
the second direction being opposite to the first direction.

2. The display apparatus (1) according to claim 1, wherein a cut portion (126f) incised toward an inner side of the flexible PCB (122) is disposed on at least one side of the connection portion (126c).

3. The display apparatus (1) according to claim 1, wherein, when a plurality of source printed circuit boards (124a, 124b) are provided, an oblique direction of said connection portion (126c) associated to one source printed circuit board (124a, 124b) is different from an oblique direction of the said connection portion (126c) associated to the other source printed circuit board (124a, 124b).

4. The display apparatus (1) according to any preceding claim, wherein a driving chip (123) is disposed on the flexible PCB (122) at a position biased to one of the source printed circuit board side(124) and the display panel side (12) and offset from a center portion of the flexible PCB.

5. The display apparatus (1) according to claim 4, wherein the driving chip (123) is disposed at the position biased to the source printed circuit board side and offset from the center of the flexible PCB, and disposed on a rear side of the display panel when the flexible PCB is bent.

6. The display apparatus (1) according to any preceding claim, wherein a plurality of source printed circuit boards are provided.

7. The display apparatus (1) according to any preceding claim, wherein a bottom chassis is disposed on a rear side of the display panel, and the flexible PCB is bent so that the source printed circuit board is disposed on a rear side of the bottom chassis.

8. The display apparatus (1) according to claim 7, wherein, when the flexible PCB is bent so as to wrap a part of the bottom chassis, the driving chip mounted in the flexible PCB is disposed so as not to be interfered with by edges of the bottom chassis.

9. The display apparatus (1) according to claim 8, wherein, when the flexible PCB is bent so as to wrap the part of the bottom chassis, the driving chip mounted in the flexible PCB is disposed on the rear side of the display panel.

10. The display apparatus (1) according to claim 8, wherein, when the flexible PCB is bent so as to wrap the part of the bottom chassis, the driving chip mounted in the flexible PCB is disposed on a front side on which the display panel is disposed.

11. The display apparatus (1) according to any preceding claim, wherein a top chassis for fixing a front side of the display panel is disposed on the front side of the display panel.

12. The display apparatus (1) according to claim 11, wherein a plurality of flexible PCBs are provided, and a separation member is positioned between the flexible PCBs adjacent to each other to support the top chassis.

13. The display apparatus (1) of any preceding claim, wherein :
the flexible PCB comprises a driving chip mounted at a position biased to the source printed circuit board side or the display panel side and offset from a center portion of the flexible PCB.

14. The display apparatus (1) of any preceding claim, wherein the display panel is a bendable display panel.

15. The display apparatus (1) of claim 14, comprising:
a plurality of source printed circuit boards configured to control the bendable display panel; and
a plurality of flexible printed circuit boards (PCBs) that connect one side of the bendable display panel and one side of the source printed circuit boards.

16. The display apparatus according to any preceding claim, wherein a width of an upper end portion or a lower end portion of the flexible PCB is longer than a width of a center portion of the flexible PCB.

## Patentansprüche

1. Anzeigevorrichtung (1), aufweisend:
ein Anzeigefeld (12), das mit einer gekrümmten Oberfläche gebildet und zur Anzeige eines Bildes konfiguriert ist;
eine Quellen-Leiterplatte (124), die zum Steuern des Anzeigefelds (12) konfiguriert ist; und
eine flexible Leiterplatte (122) (PCB), enthaltend:
einen ersten Abschnitt (126a), der mit einem gekrümmten Seitenendabschnitt des gekrümmten Anzeigefelds verbunden ist,
einen zweiten Abschnitt (126b), der mit einem Seitenendabschnitt der Quellen-Leiterplatte (124) verbunden ist; und
einen Verbindungsabschnitt (126c), der den ersten Abschnitt mit dem zweiten Abschnitt verbindet,
wobei der Verbindungsabschnitt (126c) Seitenränder (126d, 126e) hat;
**dadurch gekennzeichnet, dass**:
sich die Seitenränder (126d, 126e) des Verbindungsabschnitts (126c) in einem vorgegebenen schrägen Winkel in Bezug auf:
den einen gekrümmten Seitenendabschnitt des Anzeigefelds (12) oder
den einen Seitenendabschnitt der Quellen-PCB (124)
erstrecken, sodass der Verbindungsabschnitt (126c) länger als die kürzeste Länge zwischen dem Anzeigefeld (12) und der Leiterplatte (124) ist;
wobei sich der erste Abschnitt (126a) der flexiblen PCB (122) von einem Seitenende des Verbindungabschnitts (126c) in einer ersten Richtung weg erstreckt und
sich der zweite Abschnitt (126b) der flexiblen PCB (122) vom anderen Seitenende des Verbindungabschnitts (126c) in einer zweiten Richtung weg erstreckt;
wobei die zweite Richtung der ersten Richtung entgegengesetzt ist.

2. Anzeigevorrichtung (1) nach Anspruch 1, wobei ein Ausschnittabschnitt (126f), der zu einer Innenseite der flexiblen PCB (122) eingeschnitten ist, an mindestens einer Seite des Verbindungsabschnitts (126c) angeordnet ist.

3. Anzeigevorrichtung (1) nach Anspruch 1, wobei, wenn mehrere Quellen-Leiterplatten (124a, 124b) vorgesehen sind, eine schräge Richtung des Verbindungsabschnitts (126c), der mit einer Quellen-Leiterplatte (124a, 124b) verbunden ist, sich von einer schrägen Richtung des Verbindungsabschnitts (126c) unterscheidet, der mit der anderen Quellen-Leiterplatte (124a, 124b) verbunden ist.

4. Anzeigevorrichtung (1) nach einem vorangehenden Anspruch, wobei ein Ansteuerungschip (123) an der flexiblen PCB (122) an einer Position angeordnet ist, die zu einer der Quellen-Leiterplattenseite (124) und der Anzeigefeldseite (12) ausgerichtet und von einem mittleren Abschnitt der flexiblen PCB versetzt ist.

5. Anzeigevorrichtung (1) nach Anspruch 4, wobei der Ansteuerungschip (123) an der Position angeordnet ist, die zur Quellen-Leiterplattenseite und der ausgerichtet und vom mittleren Abschnitt der flexiblen PCB versetzt ist, und an einer Rückseite des Anzeigefelds angeordnet ist, wenn die flexible PCB gebogen ist.

6. Anzeigevorrichtung (1) nach einem vorangehenden Anspruch, wobei mehrere Quellen-Leiterplatten vorgesehen sind.

7. Anzeigevorrichtung (1) nach einem vorangehenden Anspruch, wobei ein unteres Gehäuse an einer Rückseite des Anzeigefelds vorgesehen ist und die flexible PCB so gebogen ist, dass die Quellen-Leiterplatte an einer Rückseite des unteren Gehäuses angeordnet ist.

8. Anzeigevorrichtung (1) nach Anspruch 7, wobei, wenn die flexible PCB so gebogen ist, dass sie einen Teil des unteren Gehäuses umgibt, der Ansteuerungschip, der in der flexiblen PCB montiert ist, so angeordnet ist, dass er nicht durch die Kanten des unteren Gehäuses beeinträchtigt wird.

9. Anzeigevorrichtung (1) nach Anspruch 8, wobei, wenn die flexible PCB so gebogen ist, dass sie den Teil des unteren Gehäuses umgibt, der Ansteuerungschip, der in der flexiblen PCB montiert ist, an der Rückseite des Anzeigefelds angeordnet ist.

10. Anzeigevorrichtung (1) nach Anspruch 8, wobei, wenn die flexible PCB so gebogen ist, dass sie den Teil des unteren Gehäuses umgibt, der Ansteuerungschip, der in der flexiblen PCB montiert ist, an einer Vorderseite angeordnet ist, an der das Anzeigefeld angeordnet ist.

11. Anzeigevorrichtung (1) nach einem vorangehenden Anspruch, wobei ein oberes Gehäuse zum Befestigen einer Vorderseite des Anzeigefelds an der Vorderseite des Anzeigefelds angeordnet ist.

12. Anzeigevorrichtung (1) nach Anspruch 11, wobei mehrere flexible PCBs vorgesehen sind und ein Trennungselement zwischen den nebeneinanderliegenden flexiblen PCBs positioniert ist, um das obere Gehäuse zu stützen.

13. Anzeigevorrichtung (1) nach einem vorangehenden Anspruch, wobei:
die flexible PCB einen Ansteuerungschip aufweist, der an einer Position montiert ist, die zur Quellen-Leiterplattenseite oder der Anzeigefeldseite ausgerichtet und von einem mittleren Abschnitt der flexiblen PCB versetzt ist.

14. Anzeigevorrichtung (1) nach einem vorangehenden Anspruch, wobei das Anzeigefeld ein biegsames Anzeigefeld ist.

15. Anzeigevorrichtung (1) nach Anspruch 14, aufweisend:
mehrere Quellen-Leiterplatten, die zum Steuern des biegsamen Anzeigefelds konfiguriert sind; und
mehrere flexible Leiterplatten (PCBs), die eine Seite des biegsamen Anzeigefelds und eine Seite der Quellen-Leiterplatten verbinden.

16. Anzeigevorrichtung nach einem vorangehenden Anspruch, wobei eine Breite eines oberen Endabschnitts oder eines unteren Endabschnitts der flexiblen PCB länger als eine Breite eines mittleren Abschnitts der flexiblen PCB ist.

## Revendications

1. Appareil d'affichage (1) comprenant :
un panneau d'affichage (12) formé avec une surface arrondie et configuré pour afficher une image ;
une carte de circuit imprimé source (124) configurée pour commander le panneau d'affichage (12) ; et
une carte de circuit imprimé souple (122) (PCB) comprenant :
une première partie (126a) raccordée à une partie arrondie d'extrémité latérale du panneau d'affichage arrondi,
une seconde partie (126b) raccordée à une partie d'extrémité latérale de la carte de circuit imprimé source (124) ; et
une partie de raccordement (126c) qui raccorde la première partie à la seconde partie,
la partie de raccordement (126c) ayant des bords latéraux (126d, 126e) ;
**caractérisé en ce que** :
les bords latéraux (126d, 126e) de la partie de raccordement (126c) s'étendent selon un angle oblique prédéterminé par rapport à :
ladite une partie arrondie d'extrémité latérale du panneau d'affichage (12) ou
ladite une partie d'extrémité latérale de la carte PCB source (124)
de telle sorte que la partie de raccordement (126c) soit plus longue que la longueur la plus courte entre le panneau d'affichage (12) et la carte de circuit imprimé (124) ;
dans lequel la première partie (126a) de la carte PCB souple (122) s'étend à distance d'une extrémité latérale de la partie de raccordement (126c) dans une première direction et
la seconde partie (126b) de la carte PCB souple (122) s'étend à distance de l'autre extrémité latérale de la partie de raccordement (126c) dans une seconde direction ;
la seconde direction étant opposée à la première direction.

2. Appareil d'affichage (1) selon la revendication 1, dans lequel une partie découpée (126f) incisée vers un côté interne de la carte PCB souple (122) est disposée sur au moins un côté de la partie de raccordement (126c) .

3. Appareil d'affichage (1) selon la revendication 1, dans lequel, lorsqu'une pluralité de cartes de circuit imprimé souples (124a, 124b) sont fournies, une direction oblique de ladite partie de raccordement (126c) associée à une carte de circuit imprimé source (124a, 124b) est différente d'une direction oblique de ladite partie de raccordement (126c) associée à l'autre carte de circuit imprimé source (124a, 124b).

4. Appareil d'affichage (1) selon l'une quelconque des revendications précédentes, dans lequel une puce d'attaque (123) est disposée sur la carte PCB souple (122) a une position sollicitée soit vers le côté carte de circuit imprimé source (124), soit vers le côté panneau d'affichage (12) et décalée d'une partie centrale de la carte PCB souple.

5. Appareil d'affichage (1) selon la revendication 4, dans lequel la puce d'attaque (123) est disposée à la position sollicitée vers le côté carte de circuit imprimé source et décalée du centre de la carte PCB souple et disposée sur un côté arrière du panneau d'affichage lorsque la carte PCB souple est pliée.

6. Appareil d'affichage (1) selon l'une quelconque des revendications précédentes, dans lequel une pluralité de cartes de circuit imprimé sources sont fournies.

7. Appareil d'affichage (1) selon l'une quelconque des revendications précédentes, dans lequel un châssis inférieur est disposé sur un côté arrière du panneau d'affichage et la carte PCB souple est pliée de telle sorte que la carte de circuit imprimé source soit disposée sur un côté arrière du châssis inférieur.

8. Appareil d'affichage (1) selon la revendication 7, dans lequel, lorsque la carte PCB souple est pliée de sorte à envelopper une partie du châssis inférieur, la puce d'attaque montée sur la carte PCB souple est disposée de sorte à ne pas avoir d'interférences avec des bords du châssis inférieur.

9. Appareil d'affichage (1) selon la revendication 8, dans lequel, lorsque la carte PCB souple est pliée de sorte à envelopper la partie du châssis inférieur, la puce d'attaque montée sur la carte PCB souple est disposée sur le côté arrière du panneau d'affichage.

10. Appareil d'affichage (1) selon la revendication 8, dans lequel, lorsque la carte PCB souple est pliée de sorte à envelopper la partie du châssis inférieur, la puce d'attaque montée sur la carte PCB souple est disposée sur un coté avant sur lequel panneau d'affichage est disposé.

11. Appareil d'affichage (1) selon l'une quelconque des revendications précédentes, dans lequel un châssis supérieur pour fixer un côté avant du panneau d'affichage est disposé sur le côté avant du panneau d'affichage.

12. Appareil d'affichage (1) selon la revendication 11, dans lequel une pluralité de cartes PCB souples sont fournies et un élément de séparation est positionné entre les cartes PCB souples de façon adjacente les unes par rapport aux autres pour supporter le châssis supérieur.

13. Appareil d'affichage (1) selon l'une quelconque des revendications précédentes, dans lequel :
la carte PCB souple comprend une puce d'attaque montée à une position sollicitée vers le côté carte de circuit imprimé source ou le côté panneau d'affichage et décalée d'une partie centrale de la carte PCB souple.

14. Appareil d'affichage (1) selon l'une quelconque des revendications précédentes, dans lequel le panneau d'affichage est un panneau d'affichage pliable.

15. Appareil d'affichage (1) selon la revendication 14, comprenant :
une pluralité de cartes de circuit imprimé sources configurées pour commenter le panneau d'affichage pliable ; et
une pluralité de cartes de circuit imprimé (PCB) souples qui raccordent un côté du panneau d'affichage pliable et un côté des cartes de circuit imprimé sources.

16. Appareil d'affichage selon l'une quelconque des revendications précédentes, dans lequel une largeur d'une partie d'extrémité supérieure ou d'une partie d'extrémité inférieure de la carte PCB souple est plus longue qu'une largeur d'une partie centrale de la carte PCB souple.
